# EUROPÄISCHE PATENTSCHRIFT

(11) **EP 4 121 841 B1**
(45) Veröffentlichungstag und Bekanntmachung des Hinweises auf die Patenterteilung: **06.03.2024**
(21) Anmeldenummer: 21712984.0
(22) Anmeldetag: 15.03.2021
(51) Int. Cl.: G01D 5/241, G01D 5/25, G06F 3/0362, G06F 3/0354, H03K 17/975, G06F 3/038, G06F 3/041, G06F 3/039, G06F 3/044

(54) **DREHSTELLERANORDNUNG**
ROTARY ACTUATOR ASSEMBLY
ENSEMBLE ACTIONNEUR ROTATIF

(30) Priorität: 18.03.2020 DE 102020001780
(43) Veröffentlichungstag der Anmeldung: 25.01.2023
(73) Patentinhaber: KOSTAL Automobil Elektrik GmbH & Co. KG, 58513 Lüdenscheid (DE)
(72) Erfinder: KARA, Cem, 44309 Dortmund (DE); KLISCH, Lars, 58708 Menden (DE)
(74) Vertreter: Kerkmann, Detlef
(86) Internationale Anmeldenummer: PCT/EP2021/056553
(87) Internationale Veröffentlichungsnummer: WO 2021/185772

(56) Entgegenhaltungen:
- WO-A1-2018/137944
- WO-A1-2020/011416
- DE-A1-102018 118 839
- DE-B3-102018 120 576

## Beschreibung

Die Erfindung betrifft eine Drehstelleranordnung umfassend ein Touchpanel mit einer kapazitiv sensierenden Erfassungsfläche, die eine Sensoranordnung vom Typ "mutual capacitance touch sensor" aufweist, und einen auf dieser Erfassungsfläche angeordneten Drehsteller, wobei der Drehsteller einen Stator aufweist, der mindestens eine elektrische Kontaktstelle ausbildet, die an einer festen Position der Erfassungsfläche anliegt, wobei an dem Stator ein Drehkörper drehbar gelagert ist, dessen Positionsänderungen veränderliche elektrische Signale an der mindestens einen Kontaktstelle erzeugen, welche durch das Touchpanel erfassbar sind.

Solche Drehstelleranordnungen verwenden die kapazitiv sensierende Erfassungsfläche eines Touchpanels, um die Drehstellung eines verdrehbaren Bedienelements zu ermitteln. Das Touchpanel kann dabei entweder als Touchpad oder bevorzugt als Touchscreen ausgebildet sein, wobei ein Touchscreen zusätzlich Anzeigeelemente aufweist und damit Informationen zur aktuellen Drehstellung des Bedienelements grafisch darstellen kann.

Die Dokumente DE 10 2018 120 576 B3, DE 10 2018 118 839 A1 und WO 2018/137944 A1 zeigen solche Drehstelleranordnungen, die jeweils zur Anbringung auf einer kapazitiv sensierenden Erfassungsfläche eines Touchpanels vorgesehen sind.

Zur Beeinflussung eines kapazitiv erfassenden Touchpanels ist die Änderung einer elektrischen Kapazität erforderlich. Hierzu wird bei bekannten Drehstelleranordnungen über eine elektrisch leitende Verbindung zumeist die Körperkapazität eines menschlichen Benutzers genutzt. Nachteilig hierbei ist, dass das korrekte Funktionieren von äußeren Faktoren abhängig ist. Trägt der Benutzer beispielsweise dicke Handschuhe so ist durch eine mangelnde Ankopplung eine Funktion nicht mehr gegeben.

Alternativ kann vorgesehen werden, dass der Drehsteller selber eine ausreichende Kapazität aufweist, um das Touchpanel zu beeinflussen. Dieses erfordert aber, einen ausreichend massiven Metallkörper am Drehsteller vorzusehen. Eine solche Ausführung verhindert jedoch erstens den Aufbau von besonders kleinbauenden Drehstellern und verhindert zudem zweitens, den als Bedienelement vorgesehenen Drehkörper des Drehstellers aus einem frei wählbaren Material zu fertigen.

Die WO 2020/011416 A1 zeigt eine Drehstelleranordnung gemäß dem Oberbegriff des Patentanspruchs 1. Dieser Drehsteller weist einen Stator auf, der eine Vielzahl elektrischer Kontaktstellen ausbildet, die an festen Positionen der Erfassungsfläche einer Sensoranordnung vom Typ "mutual capacitance touch sensor" anliegen. Ein an dem Stator drehbar gelagerter Drehkörper erzeugt dabei durch Positionsänderungen veränderliche elektrische Signale an den Kontaktstellen.

Die vorliegende Erfindung stellt eine alternative Ausgestaltung einer solchen Drehstelleranordnung dar, die insbesondere auch bereits mit nur einer einzigen Kontaktstelle und somit unter anderem dadurch auf besonders einfache und kostengünstige Weise realisierbar ist.

Dies gelingt der erfindungsgemäßen Drehstelleranordnung dadurch, dass der Drehkörper mit einem Sensorring gekoppelt ist, der auf einer ersten Ringfläche entlang seines Umfangs abwechselnd Kontaktflächen und Isolierflächen aufweist, die durch mindestens eine fest am Stator angeordnete, mit jeweils einer Kontaktstelle elektrisch verbundene Kontaktfeder kontaktiert werden können, und dass der Sensorring auf einer zweiten Ringfläche eine umlaufende Metallfläche aufweist, welche mit den Kontaktflächen der ersten Ringfläche elektrisch verbunden ist.

Wie nachfolgend anhand eines Ausführungsbeispiels erläutert wird, funktioniert die Drehstelleranordnung unabhängig von einer Kopplung an die elektrische Körperkapazität eines menschlichen Benutzers. Dies ist vorteilhaft für eine zuverlässige Funktion, da diese so nicht von veränderlichen äußeren Umständen abhängt. Besonders vorteilhaft ist, dass die Drehstelleranordnung auch mit beliebigen Handschuhen oder auch mit elektrisch nichtleitenden Prothesen bedient werden kann und dabei zuverlässig funktioniert.

Ebenfalls besonders vorteilhaft ist, dass die Eigenkapazität des Drehstellers von untergeordneter Bedeutung ist. Der Drehsteller braucht somit keinen massiven Metallkörper aufzuweisen, was die Realisierung von besonders kleinbauenden Drehstellern ermöglicht.

Daraus folgt als weiterer Vorteil, dass das Material aus dem der Drehkörper besteht, frei gewählt werden kann. Der Drehkörper kann so etwa vollständig aus Kunststoff bestehen oder auch aus sogenannten Echtmaterialien, wie beispielsweise Holz, gefertigt werden.

Äußerst vorteilhaft ist auch, dass der Drehkörper auch in der besonders vorteilhaften Form eines torus- oder hohlzylinderförmigen Drehringes ausgebildet sein kann. Ein derartiger Drehring weist eine innere Ausnehmung auf, durch die Teile des Touchpanels erkennbar sind. Ist das Touchpanel als ein Touchscreen ausgebildet, so können Informationen über die aktuelle Drehstellung, wie beispielsweise eine Prozentzahl zur eingestellten Größe, innerhalb des Drehrings angezeigt werden. Dieses ermöglicht wiederum, besonders beim Einsatz mehrerer Drehsteller an einem Touchscreen, eine vereinfachte Zuordnung zwischen Drehsteller und Anzeige sowie auch eine bessere Ausnutzung der Fläche des Touchscreens.

Besonders vorteilhaft ist auch, dass der Drehsteller an nur einer oder nur wenigen Kontaktstellen am Touchpanel anliegen muss und dadurch auch eine Anordnung des Drehstellers am Rand des Touchpanels mit einer nur geringen Beanspruchung der Erfassungsfläche möglich ist.

Die Funktionsweise sowie mögliche vorteilhafte Ausgestaltungen und Weiterbildungen einer erfindungsgemäßen Drehstelleranordnung sollen nachfolgend anhand eines in der Zeichnung dargestellten Ausführungsbeispiels näher erläutert werden. Es zeigen die
- Figur 1: eine erfindungsgemäße Drehstelleranordnung,
- Figur 2: eine erste Ringfläche eines Sensorrings,
- Figur 3: eine zweite Ringfläche des Sensorrings,
- Figur 4: einen Sensorring mit einer Schleifkontaktanordnung,
- Figur 5: ein Impulsdiagramm,
- Figur 6: eine erste Ansicht des Sensorrings am Drehkörper,
- Figur 7: eine zweite Ansicht des Sensorrings am Drehkörper,
- Figur 8: eine vorteilhafte Anordnung des Drehstellers an einem Touchpad,
- Figur 9: eine weitere vorteilhafte Anordnung des Drehstellers an einem Touchpad in einer Teilschnittansicht,
- Figur 10: das Funktionsprinzip eines mutual-capacitance-Touchpanels,
- Figur 11: die Funktionsweise eines mutual-capacitance-Touchpanels bei einer Berührung,
- Figur 12 und 13: die Funktionsweise einer erfindungsgemäßen Drehstelleranordnung.

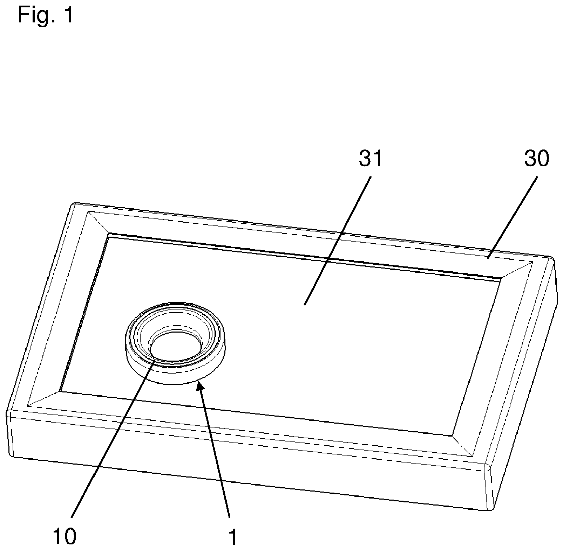

Die Figur 1 zeigt skizzenhaft eine erfindungsgemäß ausgeführte Drehstelleranordnung. Hierbei ist ein Drehsteller 1 an der Erfassungsfläche 31 eines Touchpanels 30 angeordnet.

Das Touchpanel 30 kann entweder ohne Anzeigeelemente, also als ein einfaches Touchpad ausgeführt sein, oder aber ein Display aufweisen und damit etwa einen Touchscreen ausbilden. Besonders vorteilhaft ist es, als Touchpanel 30 einen Touchscreen vorzusehen, da auf dessen Display Informationen dargestellt werden können, welche eine Betätigung des Drehstellers 1 veranschaulichen.

In jedem Fall werden die ortsauflösenden Eigenschaften der kapazitiv sensierenden Erfassungsfläche 31, sowie auch die zum Touchpanel 30 gehörende Auswerteelektronik zur Bestimmung der Drehstellung und gegebenenfalls der Drehweite des Drehstellers 1 genutzt.

Von dem Drehsteller 1 ist in der Figur 1 lediglich der Drehkörper 10 erkennbar, welcher das vom Benutzer zu verstellende Bedienelement darstellt. Der Drehkörper 10 weist vorzugsweise eine zu seiner Drehachse rotationssymmetrische Form auf und kann etwa als ein zylinderförmiger Drehknopf oder, wie hier dargestellt, als ein torus- oder hohlzylinderförmiger Drehring 10 ausgebildet sein.

Die Ausbildung des Drehkörpers 10 als ein torus- oder hohlzylinderförmiger Drehring ist besonders vorteilhaft, da dieser eine zentrale Ausnehmung aufweist. Im Falle eines als Touchscreen ausgebildeten Touchpanels 30 können dadurch auch innerhalb des Drehrings 10 Informationen dargestellt werden.

Der Drehkörper 10 ist an einem in der Zeichnung nicht dargestellten Stator angeordnet. Wie ein Stator eines Drehstellers ausgebildet und ein Drehkörper 10 an dem Stator drehbar angeordnet werden kann, ist beispielsweise aus der Druckschrift US 2014/0042004 A1 bekannt. Daher konnte auf eine bildliche Darstellung des Stators hier verzichtet werden.

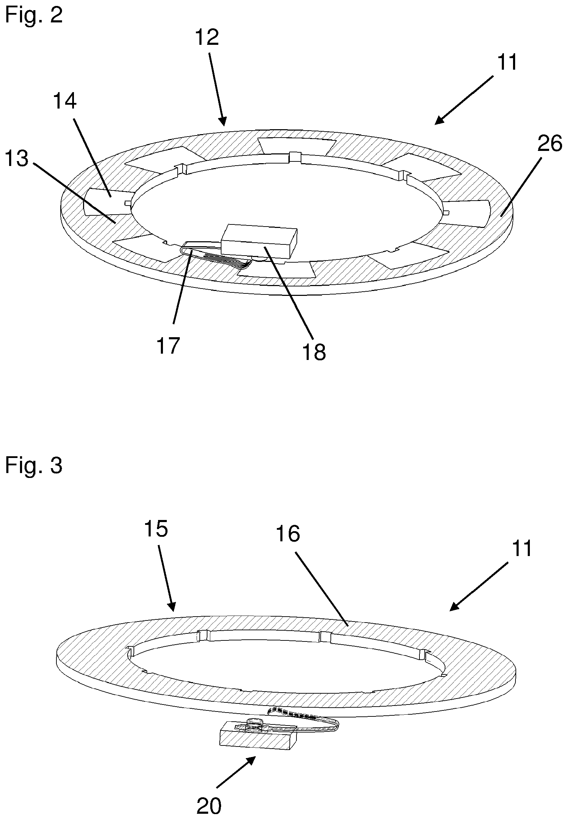

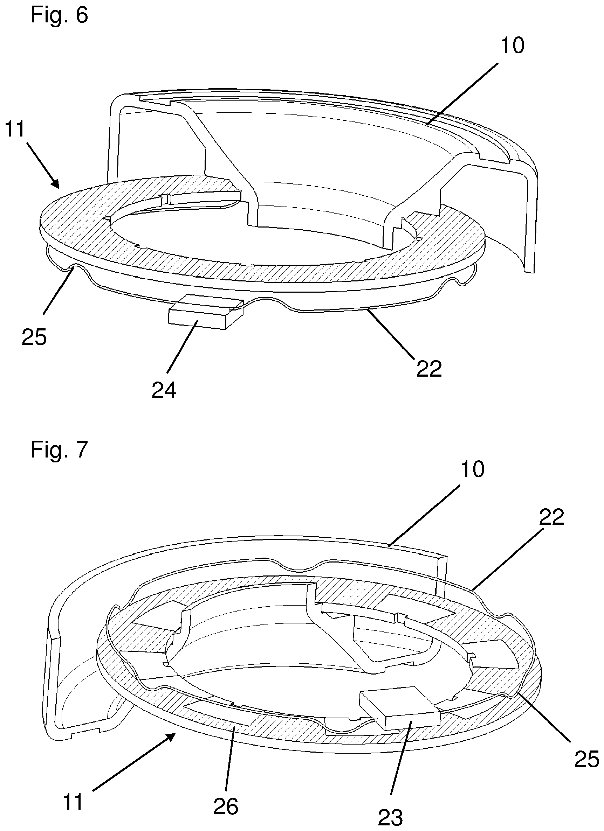

Wie die Figuren 6 und 7 zeigen, ist innerhalb des Drehkörpers 10 ein Sensorring 11 angeordnet. Der Sensorring 11, ebenfalls dargestellt in den Figuren 2 und 3, besteht aus einer kreisringförmigen doppelseitigen Leiterplatte, welche an einer ersten Ringfläche 12 umlaufend abwechselnd leitfähige und isolierende Segmente als Kontaktflächen 13 und Isolierflächen 14 aufweist. Auf ihrer dazu parallelen zweiten Ringfläche 15 ist auf dem Sensorring 11 umlaufend eine leitfähige Metallfläche 16, vorzugsweise ausgeführt als eine Kupferschicht, angeordnet.

Die leitfähigen Kontaktflächen 13 sind alle elektrisch miteinander verbunden. Diese Verbindungen können, wie in der Figur 2 dargestellt, durch einen am Rand der ersten Ringfläche 12 umlaufenden Kontaktring 26 hergestellt werden. Auf jeden Fall sind alle Kontaktflächen 13, vorzugsweise durch eine oder mehrere Durchkontaktierungen im Sensorring 13, auch mit der leitfähigen Metallfläche 16 auf der zweiten Ringfläche 15 verbunden.

In einer hier nicht dargestellten alternativen Ausführung kann der Sensorring auch als ein Metallring ausgebildet sein, der umlaufend mit mehreren isolierenden Segmenten belegt ist.

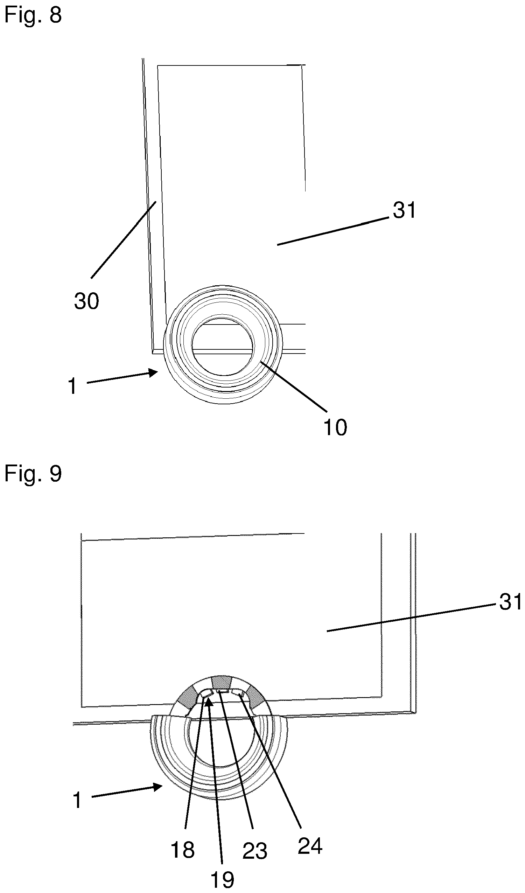

An der ersten Ringfläche 12 liegt eine Kontaktfeder 17 an, die mit einem Kontaktpad 18 mechanisch und elektrisch verbunden ist. Die Kontaktfeder 17 bildet mit dem Kontaktpad 18 einen Schleifkontakt 20 aus, der bei einer Drehung des Sensorrings 11 abwechselnd an Kontaktflächen 13 und Isolierflächen 14 anliegt. Der Schleifkontakt 20 ist mechanisch mit dem hier nicht dargestellten Stator verbunden. Das Kontaktpad 18 liegt an der Erfassungsfläche 31 des Touchpanels 30 (Figur 1) an und bildet dort eine erste Kontaktstelle 19, was in der Figur 9 andeutungsweise erkennbar ist.

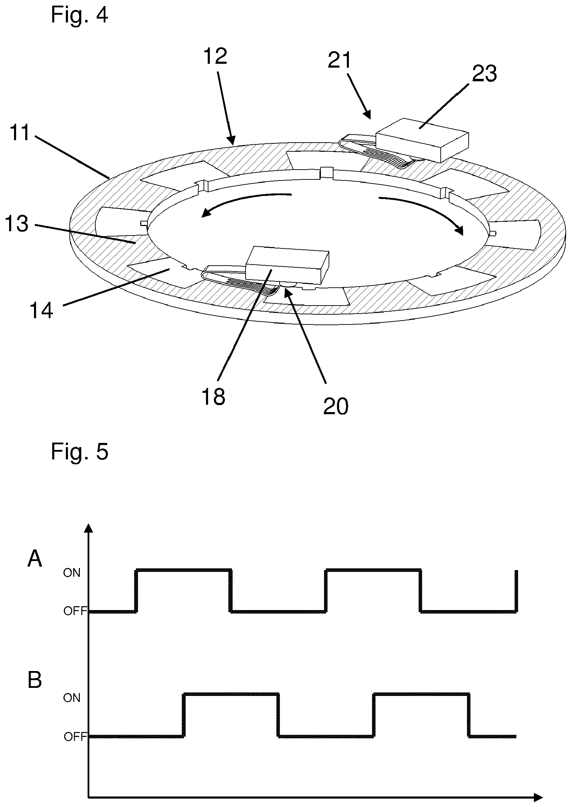

In einer bevorzugten Ausführungsform, dargestellt in der Figur 4, weist der Drehsteller sogar zwei Schleifkontakte 20, 21 auf, deren Kontaktfedern die Kontaktflächen 13 und Isolierflächen 14 an der ersten Ringfläche 12 des Sensorrings 11 abtasten.

Wie die Figur 5 andeutet, sind die Kontaktfedern der Schleifkontakte 20, 21 zu den Kontaktflächen 13 und Isolierflächen 14 so positioniert, dass die durch die Schleifkontakte 20, 21 erfassten elektrischen Signale A, B zueinander einen Phasenversatz aufweisen. Aus der Reihenfolge der erfassten Signalzustände kann so eine Auswerteelektronik des Touchpanels zusätzlich die Drehrichtung des Sensorrings 10 ermitteln.

Eine weitere vorteilhafte Ausgestaltung des Drehstellers 1 ist in den Figuren 6 und 7 dargestellt. Diese Figuren zeigen aus zwei Perspektiven den am Drehkörper 10 angeordneten Sensorring 11, sowie einen Drahtring 22, der mit dem hier nicht dargestellten Stator des Drehstellers 1 verbunden ist. Der Drahtring 22 weist mehrere Ausbuchtungen 25, die sich in Richtung des Sensorrings 11 erstrecken. Der Drahtring 22 besteht aus einem stabilen, aber dabei möglichst dünnen Draht, der eine nur geringe Eigenkapazität aufweist.

Der Durchmesser des Drahtrings 22 entspricht dem Durchmesser des Kontaktrings 26 auf dem Sensorrings 11. Mit dem Drahtring 22 ist ein weiteres Kontaktpad 23 verbunden, welches an der Erfassungsfläche 31 des Touchpanels 30 anliegt.

Durch eine Verschiebung oder Verkippung des Drehkörpers 10 relativ zum Stator gelangt der Kontaktring 26 des Sensorrings 11 in Kontakt mit wenigstens einer der Ausbuchtungen 25 des Drahtrings 22. Es entsteht so eine elektrische Verbindung zwischen den leitenden Flächen 13,16, 26 des Sensorrings 11 und dem Kontaktpad 24, die durch das Touchpanel 30 erfasst werden kann. Realisiert wird so auf einfache Weise eine zusätzliche Drucktastfunktion.

Die Figuren 8 und 9 zeigen, dass zur Ausbildung der Drehstelleranordnung der Drehkörper 10 auch weit außen am Rand des Touchpanels 30 angeordnet werden kann, so dass nur eine geringe Überdeckung des Drehstellers 1 mit der Erfassungsfläche 31 ergibt. Dies ermöglicht es, die Erfassungsfläche 31 des Touchpanels 30 besser zu nutzen oder alternativ ein relativ kleines Touchpanel 30 vorzusehen oder auch eine größere Anzahl von Drehstellern 1 an einem Touchpanel 30 zu anzuordnen.

Wie die Schnittansicht der Figur 9 verdeutlich, wird das dadurch erreicht, dass sich kein beweglicher Schleifer auf der Erfassungsfläche bewegt und zudem nur relativ wenige Kontaktpads 18, 23, 24 auf der Erfassungsfläche 31 angeordnet zu werden brauchen, die sich zudem relativ nahe beieinander befinden können. Mit den nur drei dargestellten Kontaktpads 18, 23, 24 des Drehstellers 1 lässt sich so eine Drehstelleranordnung realisieren, die eine Drehweite- und eine Drehrichtungserfassung, sowie eine Drucktastfunktion aufweist.

Für kapazitiv sensierende Touchpanel werden hauptsächlich zwei Funktionsprinzipien verwendet, die als "Eigenkapazitätsprinzip" (selfcapacitance touch sensor principle") und als "gegenseitiges Kapazitätsprinzip" (mutual capacitance touch sensor principle) bekannt sind.

Das hier nicht verwendete Eigenkapazitätsprinzip verwendet ein x-y-Raster aus offenen leitenden Elektroden, die mit einem Controller verbunden sind. Diese weisen, wie eine Kondensatorplatte, eine gewisse Kapazität relativ zur Erdmasse auf, die durch eine Sensorik erfasst werden kann. Bei der Berührung oder Annäherung an eine Elektrode ändert sich durch die zusätzliche wirkende Kapazität des menschlichen Körpers die erfasste Kapazität an der Elektrode.

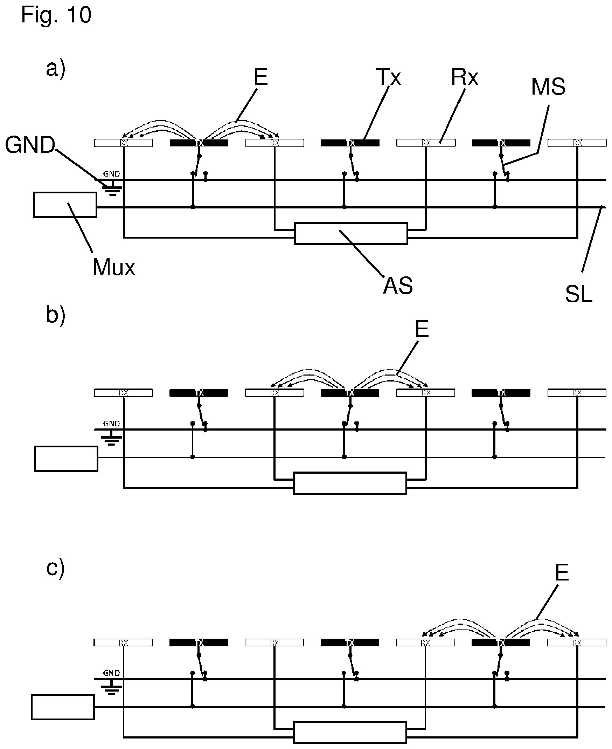

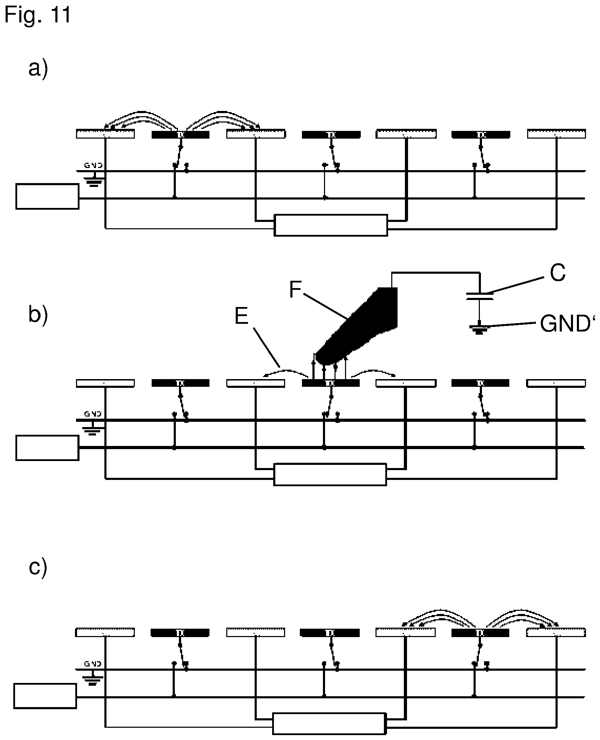

Zur Ausführung eines erfindungsgemäßen Drehstellers wird ein Touchpad vom Typ "mutual capacitance touch sensor" vorausgesetzt, welches zur Berührungserkennung das "gegenseitige Kapazitätsprinzip" verwendet. Dieses Prinzip ist in den Figuren 10 und 11 skizzenhaft dargestellt.

Ein nach diesem Funktionsprinzip arbeitendes Touchpad weist eine zweidimensionale Matrix aus abwechselnd angeordneten Sendeelementen Tx und Empfangselementen Rx auf. Für die Erläuterung der Funktion ist in den Figuren 11 bis 13 jeweils nur ein kurzer eindimensionaler Abschnitt aus dieser Matrix dargestellt.

Die Empfangselemente Rx (hier hell dargestellt) sind alle gemeinsam mit einer Auswerteschaltung AS verbunden. Die Sendeelemente Tx (dunkel dargestellt) sind mit einem Multiplexer Mux verbunden, der alle Sendeelemente Tx reihen- und spaltenweise nacheinander mit einem Sendesignal beaufschlagt. Dazu ist, über den hier schematisch als Umschalter dargestellten Multiplexschalter MS immer nur ein Sendeelement Tx mit einer Sendesignalleitung SL verbunden, während gleichzeitig alle anderen Sendeelemente Tx an die Gerätemasse GND geschaltet sind.

Wie aus den drei Teilfiguren a) bis c) der Figur 10 ersichtlich ist, wandert so ein elektrisches Feld E von einem Sendeelement Tx zu nächsten und wird jeweils durch die zum jeweiligen Sendeelement Tx benachbarten Empfangselemente Rx erfasst. Solange kein Berührungsereignis stattfindet, ist zu jedem Zeitpunkt die von Empfangselemente Rx erfasste und von der Auswerteschaltung AS registrierte Gesamtsignalstärke immer annähernd gleich groß.

Dieses ändert sich, wenn, wie in der Teilfigur b) der Figur 11 angedeutet, ein menschlicher Finger F in die Nähe eines der Sendeelemente Tx gebracht wird.

Wenn das berührte Sendeelement Tx durch den Multiplexer Mux aktiv geschaltet ist, koppelt der Finger F kapazitiv an das vom Sendeelement Tx ausgehende elektrische Feld E an. Durch die relativ große Kapazität C des menschlichen Körpers besteht über diesen eine weitere kapazitive Kopplung zur Erdmasse GND`, über die das elektrische Feld E deutlich geschwächt wird. Die Auswerteschaltung AS registriert zu diesem Zeitpunkt eine verringerte Stärke des elektrischen Feldes E an den Empfangselementen Rx. Da sowohl der Multiplexer Mux als auch die Auswerteschaltung AS beide zur gleichen Touchpanelelektronik gehören, kann die Auswerteschaltung AS die Koordinaten des zu diesem Zeitpunkt aktiven Sendeelements Tx leicht ermitteln.

Dabei können nach diesem Funktionsprinzip auch Berührungen an mehreren Stellen innerhalb eines Multiplexzyklusses, zwar nicht exakt gleichzeitig, aber doch im Millisekundenabstand sehr schnell hintereinander und damit "quasi gleichzeitig" erkannt werden.

Bei der erfindungsgemäßen Drehstelleranordnung wird statt eines menschlichen Fingers F ein Sensorring SR gemäß der vorstehenden Beschreibung eingesetzt. Ein solcher Sensorring SR weist im Vergleich zu einem menschlichen Körper eine nur sehr geringe elektrische Kapazität auf. Daher erscheint es zunächst überraschend, dass der Sensorring SR an einem kapazitiven Touchpanel ein auswertbares Signal erzeugt.

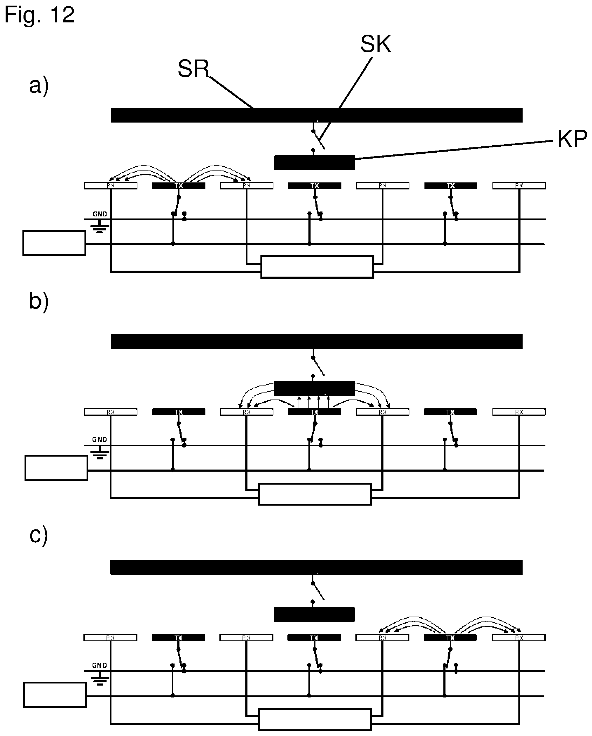

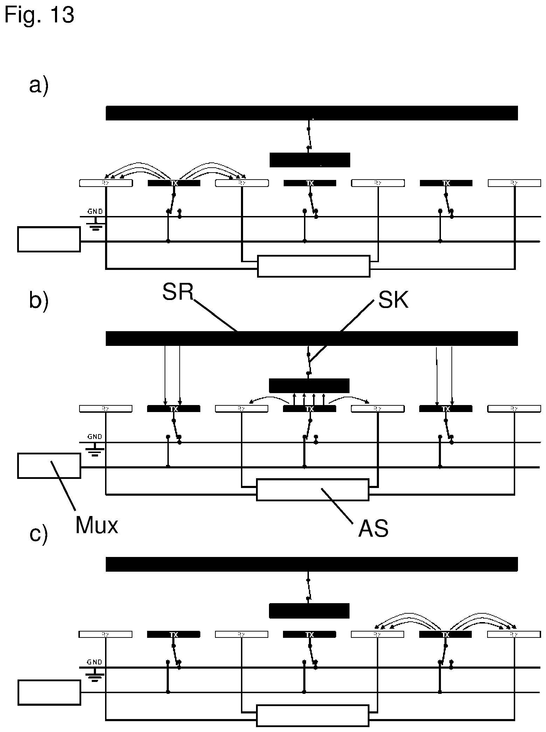

Die elektrische Funktionsweise des erfindungsgemäßen Drehstellers wird in den Figuren 12 und 13 durch einen schematisch dargestellten Sensorring SR und einen durch ein Schaltersymbol dargestellten Schleifkontakt SK dargestellt. Die Berührung einer elektrischen leitenden Kontaktfläche 13 durch die Kontaktfeder 17 eines Schleifkontakts 20, 21 (Figuren 2 und 4) wird durch einen geschlossenen Schalter dargestellt, die Berührung einer der Isolierflächen 14 entsprechend durch einen offenen Schalter. Der Schleifkontakt SK verbindet beziehungsweise trennt so die elektrisch miteinander verbundenen leitenden Flächen des Sensorrings SR mit einem Kontaktpad KP, welches an ein darunter liegendes Sendeelement Tx kapazitiv gekoppelt ist.

Ist dieses Sendeelement Tx durch den Multiplexer Mux aktiv geschaltet und der Schleifkontakt SK geöffnet, so unterscheidet sich die von den Empfangselementen Rx registrierte elektrische Feldstärke E (Figur 12, Teilfigur b) nicht von den Feldstärken, die bei anderen aktiven Sendeelementen erfasst wird (Teilfiguren a) und c)), da die Eigenkapazität eines Kontaktpads KP relativ gering ist.

Dieses ändert sich, sobald der Schleifkontakt SK geschlossen ist. Wie die Teilfigur b) der Figur 13 zeigt, stellt der geschlossene Schleifkontakt SK eine galvanische Verbindung zwischen dem Kontaktpad KP und dem Sensorring SR her. Hieraus ergibt sich einerseits eine kapazitive Kopplung zwischen dem aktiven Sendelement Tx und dem Kontaktpad KP und andererseits eine weitere kapazitive Kopplung durch eine ausreichend nahe Anordnung der leitenden Flächen des Sensorrings SR zu den umliegenden inaktiven Sendeelementen Tx.

Da alle inaktiven Sendeelemente durch den Multiplexer mit der Gerätemasse GND verbunden sind, können sich über deren kapazitive Anbindung Ladungen verschieben, was die von den Empfangselementen Rx rund um das aktive Sendeelement Tx registrierte Feldstärke verringert. Ein geschlossener Schleifkontakt SK kann so durch die Auswerteschaltung AS von einem geöffneten Schleifkontakt SK unterschieden werden.

Auf entsprechende Weise können natürlich auch mehrere Schleifkontakte 20, 21 an einem Drehsteller 1 ausgewertet werden bzw. kann auch eine Druckbetätigung auf den Drehkörper 10 für eine Tastschaltfunktion erkannt werden, wobei hier die Berührung des Kontaktrings 26 mit dem Drahtring 22 (Figuren 6 und 7) die Rolle eines geschlossenen Schleifkontakts SK übernimmt.

### Bezugszeichen

- 1: Drehsteller
- 10: Drehkörper (Drehring)
- 11: Sensorring
- 12: erste Ringfläche
- 13: Kontaktfläche(n)
- 14: Isolierflächen
- 15: zweite Ringfläche
- 16: Metallfläche
- 17: Kontaktfeder
- 18: Kontaktpad
- 19: Kontaktstelle
- 20: erster Schleifkontakt
- 21: zweiter Schleifkontakt
- 22: Drahtring
- 23: Kontaktpad
- 24: Kontaktpad
- 25: Ausbuchtungen
- 26: Kontaktring
- 30: Touchpanel
- 31: Erfassungsfläche

- A, B: elektrische Signale
- AS: Auswerteschaltung
- C: Kapazität (eines Menschen)
- F: Finger
- GND: (Geräte-)Masse
- GND': (Erd-)Masse
- KP: Kontaktpad
- MS: Multiplexschalter
- Rx: Empfangselemente
- SK: Schleifkontakt
- SL: Sendesignalleitung
- SR: Sensorring
- Mux: Multiplexer
- Tx: Sendeelemente

## Patentansprüche

1. Drehstelleranordnung umfassend ein Touchpanel (30) mit einer kapazitiv sensierenden Erfassungsfläche (31), die eine Sensoranordnung vom Typ "mutual capacitance touch sensor" aufweist, und einen auf dieser Erfassungsfläche (31) angeordneten Drehsteller (1), wobei der Drehsteller (1) einen Stator aufweist, der mindestens eine elektrische Kontaktstelle (19) ausbildet, die an einer festen Position der Erfassungsfläche (31) anliegt, wobei an dem Stator ein Drehkörper (10) drehbar gelagert ist, dessen Positionsänderungen veränderliche elektrische Signale (A, B) an der mindestens einen Kontaktstelle (19) erzeugen, welche durch das Touchpanel (30) erfassbar sind, **dadurch gekennzeichnet, dass** der Drehkörper (10) mit einem Sensorring (11) gekoppelt ist, der auf einer ersten Ringfläche (12) entlang seines Umfangs abwechselnd Kontaktflächen (13) und Isolierflächen (14) aufweist, die durch mindestens eine fest am Stator angeordnete, mit jeweils einer Kontaktstelle (19) elektrisch verbundene Kontaktfeder (17) kontaktiert werden können, und dass der Sensorring (11) auf einer zweiten Ringfläche (15) eine umlaufende Metallfläche (16) aufweist, welche mit den Kontaktflächen (13) der ersten Ringfläche (12) elektrisch verbunden ist.

2. Drehstelleranordnung nach Anspruch 1, **dadurch gekennzeichnet, dass** der Drehkörper (10) aus einem elektrisch nichtleitenden Material besteht.

3. Drehstelleranordnung nach Anspruch 1, **dadurch gekennzeichnet, dass** der Drehkörper (10) als ein Drehknopf oder als ein torus- oder hohlzylinderförmiger Drehring ausgebildet ist.

4. Drehstelleranordnung nach Anspruch 1, **dadurch gekennzeichnet, dass** zwei Kontaktfedern am Sensorring (11) vorgesehen sind.

5. Drehstelleranordnung nach Anspruch 1, **dadurch gekennzeichnet, dass** der Sensorring (11) durch eine kreisringförmige doppelseitige Leiterplatte ausgebildet ist.

6. Drehstelleranordnung nach Anspruch 1, **dadurch gekennzeichnet, dass** der Drehkörper (10) gegen den Stator verschiebbar oder verkippbar angeordnet ist, und dass ein am Stator angeordneter Drahtring (22) vorgesehen ist, der mit einer am an der Erfassungsfläche (31) des Touchpanels (30) anliegenden Kontaktstelle elektrisch verbunden ist und der im Falle Verschiebung oder Verkippung des Drehkörpers einen am Sensorring (11) angeordneten Kontaktring (26) berührt.

## Claims

1. Rotary actuator arrangement comprising a touch panel (30) with a capacitively sensing detection surface (31), which has a sensor arrangement of the "mutual capacitance touch sensor" type, and a rotary actuator (1) arranged on this detection surface (31), the rotary actuator (1) having a stator, which forms at least one electrical contact point (19) which bears against a fixed position of the detection surface (31), a rotary body (10) being rotatably mounted on the stator, the changes in position of which rotary body generate variable electrical signals (A, B) at the at least one contact point (19), which can be detected by the touch panel (30), **characterized in that**, that the rotating body (10) is coupled to a sensor ring (11) which has alternating contact surfaces (13) and insulating surfaces (14) on a first annular surface (12) along its circumference, which surfaces can be contacted by at least one contact spring (17) arranged fixedly on the stator and electrically connected to a respective contact point (19), and **in that** the sensor ring (11) has a circumferential metal surface (16) on a second annular surface (15), which is electrically connected to the contact surfaces (13) of the first annular surface (12).

2. Rotary actuator arrangement according to claim 1, **characterized in that** the rotary body (10) consists of an electrically non-conductive material.

3. Rotary actuator arrangement according to claim 1, **characterized in that** the rotary body (10) is designed as a rotary knob or as a toroidal or hollow cylindrical rotary ring.

4. Rotary actuator arrangement according to claim 1, **characterized in that** two contact springs are provided on the sensor ring (11).

5. Rotary actuator arrangement according to claim 1, **characterized in that** the sensor ring (11) is formed by a circular ring-shaped double-sided printed circuit board.

6. Rotary actuator arrangement according to claim 1, **characterized in that** the rotary body (10) is arranged so as to be displaceable or tiltable relative to the stator, and **in that** a wire ring (22) is provided which is arranged on the stator and is electrically connected to a contact point which bears against the detection surface (31) of the touch panel (30) and which, in the event of displacement or tilting of the rotary body, touches a contact ring (26) arranged on the sensor ring (11).

## Revendications

1. Dispositif de réglage rotatif comprenant un panneau tactile (30) avec une surface de détection (31) à détection capacitive, qui présente un agencement de capteurs du type "mutual capacitance touch sensor", et un actionneur rotatif (1) disposé sur cette surface de détection (31), l'actionneur rotatif (1) présentant un stator, qui forme au moins un point de contact électrique (19) qui s'applique à une position fixe de la surface de détection (31), un corps rotatif (10) étant monté à rotation sur le stator, dont les changements de position génèrent des signaux électriques variables (A, B) sur le au moins un point de contact (19), qui peuvent être détectés par l'écran tactile (30), **caractérisé en ce que** le corps rotatif (10) est couplé à une bague de capteur (11) qui présente sur une première surface annulaire (12), le long de sa périphérie, une alternance de surfaces de contact (13) et de surfaces isolantes (14) qui peuvent être mises en contact par au moins un ressort de contact (17) disposé de manière fixe sur le stator et relié électriquement à chaque fois à un point de contact (19), et **en ce que** la bague de capteur (11) présente sur une deuxième surface annulaire (15) une surface métallique périphérique (16) qui est reliée électriquement aux surfaces de contact (13) de la première surface annulaire (12).

2. Dispositif de réglage rotatif selon la revendication 1, **caractérisé en ce que** le corps rotatif (10) est constitué d'un matériau non conducteur de l'électricité.

3. Dispositif de réglage rotatif selon la revendication 1, **caractérisé en ce que** le corps rotatif (10) est réalisé sous la forme d'un bouton rotatif ou d'un anneau rotatif en forme de tore ou de cylindre creux.

4. Dispositif de réglage rotatif selon la revendication 1, **caractérisé en ce que** deux ressorts de contact sont prévus sur la bague de capteur (11).

5. Dispositif de réglage rotatif selon la revendication 1, **caractérisé en ce que** bague de capteur (11) est formé par une carte de circuit imprimé double face en forme d'anneau circulaire.

6. Dispositif de réglage rotatif selon la revendication 1, **caractérisé en ce que** le corps rotatif (10) est disposé de manière à pouvoir être déplacé ou basculé par rapport au stator, et **en ce qu'**il est prévu une bague en fil métallique (22) disposée sur le stator, qui est reliée électriquement à un point de contact situé sur la surface de détection (31) de l'écran tactile (30) et qui, en cas de déplacement ou de basculement du corps rotatif, touche une bague de contact (26) disposée sur la bague de capteur (11).
